# EUROPEAN PATENT SPECIFICATION

(11) **EP 2 527 962 B1**
(45) Date of publication and mention of the grant of the patent: **21.11.2018**
(21) Application number: 12162144.5
(22) Date of filing: 29.03.2012
(51) Int. Cl.: G06F 3/046, G06F 3/041

(54) **Integrated digitizer display**
Integrierte Digitalisiergeräteanzeige
Affichage de numériseur intégré

(30) Priority: 24.05.2011 KR 20110049135
(43) Date of publication of application: 28.11.2012
(73) Proprietor: Samsung Electronics Co., Ltd., Suwon-si, Gyeonggi-do, 443-742 (KR)
(72) Inventor: Lee, Joo-Hoon, 442-742 Gyeonggi-do (KR)
(74) Representative: Grünecker Patent- und Rechtsanwälte PartG mbB

(56) References cited:
- EP-A2- 2 261 986
- WO-A2-2005/062162
- US-A1- 2011 090 171

## Description

### BACKGROUND OF THE INVENTION

### 1. Field of the Invention

The present invention relates generally to a display, and more particularly, to a display in which an Electromagnetic Resonance (EMR) digitizer is integrated (hereinafter "integrated digitizer display").

### 2. Description of the Related Art

A display module may be equipped with a digitizer that enables a user to input an electrical graphic signal by touching a screen on which an image is displayed. A Liquid Crystal Display (LCD) equipped with such a digitizer is often used for personal mobile terminals such as notebook computers, all-in-one Personal Computers (PCs), tablet PCs, smart phones, and Portable Multimedia Players (PMPs). Unlike input devices such as a keyboard and a mouse, the digitizer is provided to input information about the point that a user has touched on a screen by a finger or a stylus pen. Accordingly, digitizers are suitable for graphic tasks such as Computer-Aided Design (CAD) and are widely used to provide intuitive and convenient user interfaces.

The digitizer is also commonly referred to as "a touchscreen" or "an Electric Graphic Input Panel (EGIP)."

Further, digitizers may be classified into resistive digitizers, capacitive digitizers, and ElectroMagnetic Resonance (EMR) digitizers (or electromagnetic digitizers), depending on the techniques used to detect the point touched by a user.

A resistive digitizer senses a pressed point by detecting a change in current while a DC voltage is applied thereto. The resistive digitizer senses that two thin conductive layers on a screen directly contact each other as a result of pressure applied by a user's finger or a stylus pen. The resistive digitizer can sense both a conductive detection object and a nonconductive detection object because it senses a point by pressure.

A capacitive digitizer senses a touched point by capacitance coupling while an AC voltage is applied thereto. The capacitive digitizer can sense only a conductive detection object and uses a predetermined contact area to make a change in sensible capacitance. Thus, the capacitive digitizer can sense a point touched by a human finger, but can hardly sense a point touched by a conductive tip due to its small contact area.

An EMR digitizer uses a digitizer sensor substrate including a plurality of coils. When a user moves a pen, the pen is driven by an AC signal to generate a vibrating magnetic field. The vibrating magnetic field induces a signal in the coil, and the position of the pen is detected based on the signal induced in the coil.

Accordingly, the EMR digitizer has a digitizer substrate equipped with a plurality of coils, and detects the position of a pen by sensing an electromagnetic change caused by the pen being placed close to the digitizer. Thus, unlike the resistive digitizer, the EMR digitizer is not necessarily disposed at the front of a display module, but can also be disposed at the rear of the display module.

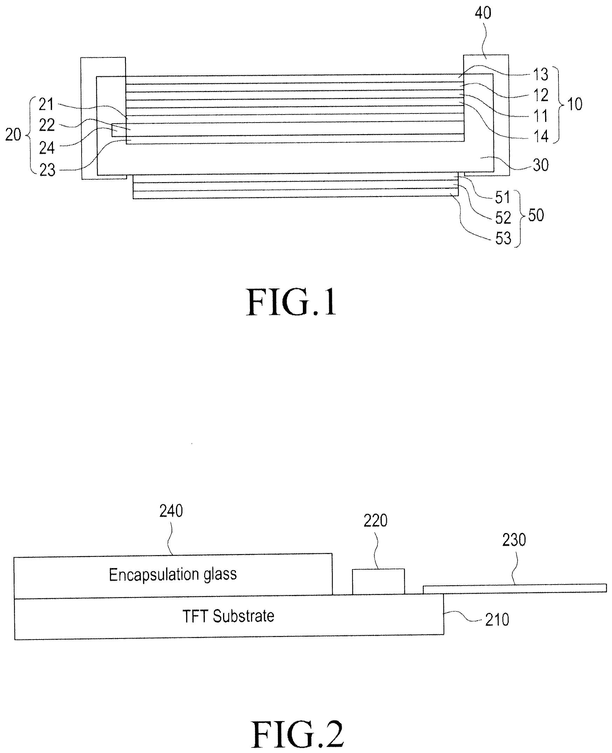

FIG. 1 illustrates a conventional display equipped with a digitizer.

Referring to FIG. 1, the conventional display equipped with a digitizer includes an LCD module and a digitizer module 50 located under the LCD module

More specifically, the LCD module includes a liquid crystal panel 10, a backlight assembly 20, a molded frame 30 supporting the liquid crystal panel 10 and the backlight assembly 20, and a metal bracket 40 covering the periphery of the molded frame 30. The liquid crystal panel 10 includes a front polarization plate 13, a color filter substrate 12, a Thin Film Transistor (TFT) substrate 11, and a rear polarization plate 14. Further, the liquid crystal panel 10 includes the color filter substrate 12 corresponding to liquid crystal cells forming unit pixels and arranged in a matrix, where the liquid crystal panel 10 forms an image by controlling the optical transmittance of the liquid crystal cells according to image signal information received from a control unit (not illustrated).

The backlight assembly 20 includes an optical sheet 21, a light guide plate 22, a reflection sheet 23, and a lamp unit 24. The light guide plate 22 is disposed in parallel to the rear side of the liquid crystal panel 10, the lamp unit 24 is disposed along at least one side of the light guide plate 22 to supply light, the optical sheet 21 is disposed on the front side of the light guide plate 22 to diffuse and concentrate light heading to the liquid crystal panel 10, and the reflection sheet 23 provided on the rear side of the light guide plate 22.

The digitizer module 50 includes an EMR sensor substrate 51, a magnetic sheet 52, and an electromagnetic shield substrate 53.

In the conventional integrated digitizer display module, there should be no metal structure disposed between the LCD module and the EMR sensor substrate 51, which may interrupt an electromagnetic field generated in the EMR sensor substrate 51. Thus, the robust design of the display module should be achieved by applying a frame to the side of the display. Also, the electromagnetic shield substrate 53 should be installed under the EMR sensor substrate 51 to prevent an electromagnetic interference with a main board disposed under the digitizer module 50.

However, when the digitizer module 50 is disposed under the display, the total thickness of the display module increases. Also, sensor inaccuracy problems may arise due to an alignment error during the coupling of the display and the digitizer module 50. Thus, an additional sensor may be required, causing an additional cost increase.

Additionally, a conventional EMR digitizer includes a sensor board having orthogonal loop coils arranged on it, a control Integrated Circuit (IC), and a pen interacting with the sensor board, all of which are formed on a Flexible Printed Circuit Board (FPCB) or a Printed Circuit Board (PCB).

When using an LCD display, a digitizer sensor board should be disposed under a BackLight Unit (BLU) for integration of the display and the digitizer. However, in this case, the addition of the digitizer sensor board increases the material cost and the total thickness of the display module. Also, the accuracy of input coordinates may decrease due to an alignment error during the assembly of the digitizer sensor board and the display module.

International patent application WO 2005/062162 A2 teaches electronic paper including integrally an input portion and a display portion and employing an electromagnetic induction type pen input scheme. A sensor substrate comprising loop coils is provided at a rear surface of a TFT substrate and an electronic paper display portion is provided at a front surface of the TFT substrate wherein an organic electroluminescence device may be used.

### SUMMARY OF THE INVENTION

Accordingly, the present invention has been designed to address at least the problems and/or disadvantages described above and to provide at least the advantages described below.

An aspect of the present invention is to provide an integrated digitizer display that minimizes alignment error and reduces total thickness and cost.

In accordance with an aspect of the present invention, an integrated digitizer display according to claim 1 is provided.

### BRIEF DESCRIPTION OF THE DRAWINGS

The above and other aspects, features, and advantages of certain embodiments of the present invention will be more apparent from the following description taken in conjunction with the accompanying drawings, in which:
FIG. 1 illustrates a conventional display equipped with a digitizer; FIG. 2 illustrates an Active Matrix Organic Light Emitting Display (AMOLED) according to an embodiment of the present invention;
FIG. 3 illustrates a digitizer module according to an embodiment of the present invention;
FIG. 4 illustrates an integrated digitizer display according to the present invention;
FIG. 5 illustrates coil arrays for an EMR sensor grid of a conventional digitizer;
FIG. 6 illustrates a loop coil of a conventional digitizer; FIG. 7 illustrates a coil electrode formed in each electrode layer in an integrated digitizer display according to an embodiment of the present invention;
FIG. 8 illustrates an example of the formation of a contact hole in an integrated digitizer display according to an embodiment of the present invention; and
FIG. 9 is a sectional view illustrating a digitizer module in an integrated digitizer display according to an embodiment of the present invention.

### DETAILED DESCRIPTION OF EMBODIMENTS OF THE INVENTION

Various embodiments of the present invention will be described below in detail with reference to the accompanying drawings. In the following description, specific details such as detailed configurations and components are merely provided to assist the overall understanding of these embodiments of the present invention. Therefore, it should be apparent to those skilled in the art that various changes and modifications of the embodiments described herein can be made without departing from the scope of the present invention as shown in the appended claims. In addition, detailed descriptions of well-known functions and constructions will be omitted to avoid obscuring the subject matter of the present invention.

FIG. 2 illustrates an AMOLED according to an embodiment of the present invention.

Unlike an LCD, an OLED is a self-luminous display that does not use a backlight unit. Therefore, in the AMOLED in FIG. 2, without using a sensor board, a loop antenna is formed under a TFT substrate 210 on which an organic light emitting layer is formed, and an EMR sensor grid is formed in a display, regardless of the optical characteristics of the display.

Referring to FIG. 2, the AMOLED includes a TFT substrate 210 on which a TFT and an organic light emitting layer are formed, and an encapsulation glass 240.

A circuit formed on the TFT substrate 210 is connected to a display driving IC 220 that is Chip On Glass (COG)-bonded to the TFT substrate 210, and an external interface is formed by Anisotropic Conductive Film (ACF) bonding of an FPCB 230.

Although not illustrated in FIG. 2, the AMOLED includes a gate, a data line, a TFT, an organic light emitting layer, and an electrode layer formed on the top surface of the TFT substrate 210, and emits light toward the encapsulation glass 240.

In such a top-emission type, the EMR sensor grid may be formed on the top surface of the TFT substrate 210, under the organic light emitting layer, and may be formed on the bottom surface of the TFT substrate 210.

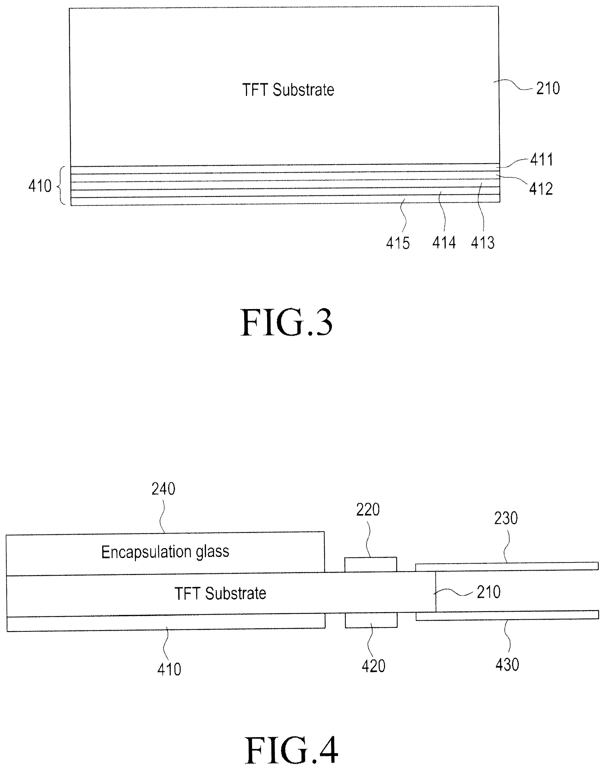

FIG. 3 illustrates a digitizer module according to an embodiment of the present invention.

Referring to FIG. 3, the digitizer module includes an EMR sensor grid 410 including a first electrode layer 411 disposed under the TFT substrate 210, a second electrode layer 413 disposed under the first electrode layer 411, a first dielectric layer 412 disposed between the first electrode layer 411 and the second electrode layer 413, a second dielectric layer 414 disposed under the second electrode layer 413, and a magnetic shield 415 disposed under the second dielectric layer 414.

Because the EMR sensor grid 410 is irrelevant to the optical characteristics of the display, it has little limitation in terms of the position, the thickness, and the critical dimension of the electrode. Also, an EMR loop coil can be easily formed because it is given a designing freedom including a low resistance required in the EMR type.

FIG. 4 illustrates an integrated digitizer display according to the present invention.

Referring to FIG. 4, the integrated digitizer display includes a TFT substrate 210 on which a TFT and an organic light emitting layer are formed, a display driving IC 220, an FPCB 230, and an encapsulation glass 240, as described above in reference to FIG. 2.

Further, the integrated digitizer display includes a sensor electrode (or sensor grid) 410 of a digitizer, formed on a surface opposite to the surface of the TFT substrate 210 on which the TFT is formed. An EMR IC 420 for driving the digitizer and an FPCB for an external interface of the digitizer are also disposed on the surface of the TFT substrate 210 on which the sensor electrode 410 is formed.

As described in reference to FIG. 3, the sensor electrode 410 includes a first electrode layer formed under the TFT substrate 210, a second electrode layer formed under the first electrode layer, and two dielectric layers formed under the first electrode layer and the second electrode layer, respectively. A magnetic shield is disposed under the sensor electrode 410.

More specifically, the EMR IC 420 is bonded to the bottom surface of the TFT substrate 210 (i.e., the surface on which the sensor grid 410 is formed) and a plurality of channels are connected by an EMR IC 420 on the bottom surface of the TFT substrate 210. The external interface is formed by ACF bonding of the FPCB 430, thus simplifying an interface with a main board and providing a structure advantageous for mounting.

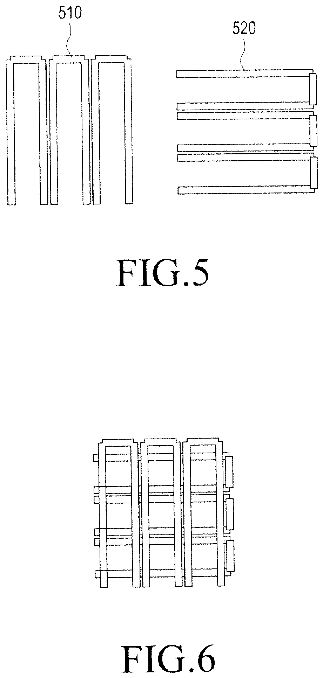

FIG. 5 illustrates coil arrays of an EMR sensor grid of a conventional digitizer.

Referring to FIG. 5, an EMR sensor grid includes a vertically-long rectangular coil array 510 and a horizontally-long rectangular coil array 520 that are orthogonal to each other.

FIG. 6 illustrates a loop coil of a conventional digitizer.

Referring to FIG. 6, when the vertically-long rectangular coil array 510 and the horizontally-long rectangular coil array 520 of FIG. 5 are joined, a loop coil shape is formed. In this case, loop coil antennas may overlap each other, and each loop coil operates as an R channel for detecting a signal from a pen and a drive (T) for forming a magnetic field.

In the prior art, such a sensor has coils as illustrated in FIG. 6 formed on a top surface and a bottom surface of a PCB substrate, i.e., a double-side PCB structure is used.

However, according to an embodiment of the present invention, such a circuit is formed on a bottom surface of the TFT substrate 210.

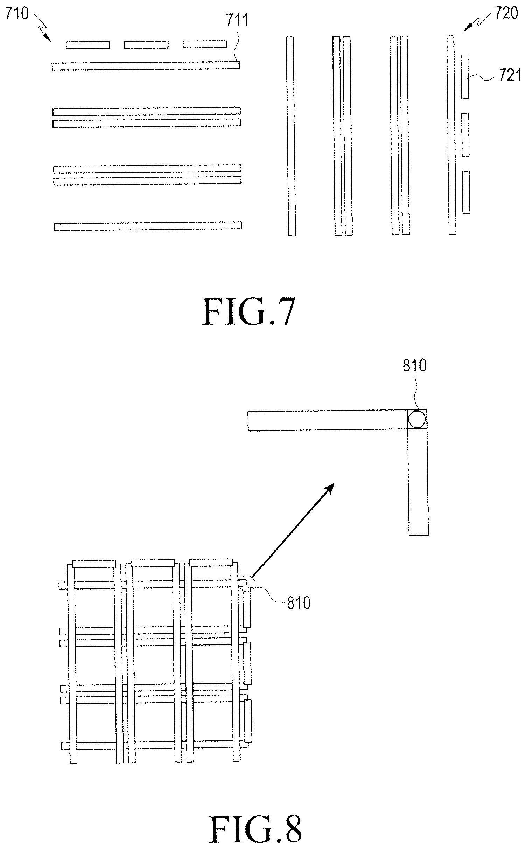

FIG. 7 illustrates a coil electrode formed in each electrode layer in an integrated digitizer display according to an embodiment of the present invention.

According to an embodiment of the present invention coil electrodes are formed on the first electrode layer 411 and the second electrode layer 413, as illustrated in FIG. 3.

Referring to FIG. 7, for example, a horizontal coil electrode 710 is formed on the first electrode layer 411, and a vertical coil electrode 720 is formed on the second electrode layer 413.

FIG. 8 illustrates an example of the formation of a contact hole in an integrated digitizer display according to an embodiment of the present invention.

Referring to FIG. 8, in order to connect the coil electrodes of the respective electrode layers to form independent loop coils, a contact hole 810 may be formed by patterning the dielectric layer.

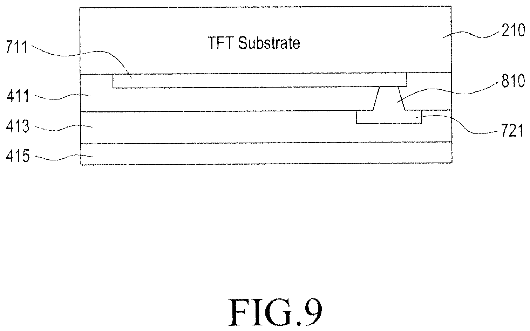

FIG. 9 illustrates a sectional view of a digitizer module in an integrated digitizer display according to an embodiment of the present invention. Specifically, FIG. 9 illustrates a sectional view taken along the contact hole 810 of FIG. 8 in the integrated digitizer display including electrode layers on which electrode coils illustrated in FIG. 7 are formed as illustrated in FIG. 8. Accordingly, the contact hole 810 is formed to connect a horizontal coil electrode 711 formed in the first electrode layer 411 disposed under the TFT substrate 210, and a vertical coil electrode 721 formed in the second electrode layer 413.

As described above, in accordance with an embodiment of the present invention, an integrated EMR digitizer OLED display module is provided having a digitizer sensor electrode formed on a surface opposite to a surface of a TFT substrate on which a TFT is formed, thus making it possible to reduce the thickness of the integrated digitizer display. Also, cost can be reduced because a separate sensor substrate is not required. Further, it is possible to minimize an alignment error that often occurs in conventional integrated digitizer displays.

While the present invention has been shown and described with reference to certain embodiments thereof, it will be understood by those skilled in the art that various changes in form and details may be made therein without departing from the scope of the present invention as defined by the appended claims and their equivalents.

## Claims

1. An integrated digitizer display comprising:
a Thin Film Transistor, TFT, substrate (210), on a first surface of which a TFT and an organic light emitting layer are formed;
a sensor electrode (410) formed on a second surface of the TFT substrate (210), and
an Integrated Circuit, IC (420), bonded on the second surface of the TFT substrate (210) for driving the integrated digitizer display, wherein
the second surface is opposite to the first surface,
wherein the sensor electrode (410) is configured to sense an external magnetic field,
wherein the sensor electrode (410) directly contacts the TFT substrate (210), and
wherein a plurality of channels for the sensor electrode (410) are connected by the IC (410) on the second surface of the TFT substrate (210).

2. The integrated digitizer display of claim 1, further comprising a Flexible Printed Circuit Board, FPCB (430), disposed on the second surface of the TFT substrate (210) for being an external interface of the digitizer.

3. The integrated digitizer display of claim 1, further comprising a magnetic shield (415) disposed under the sensor electrode (410).

4. The integrated digitizer display of claim 1, wherein the sensor electrode (410) comprises:
a first electrode layer (411) formed under the TFT substrate (210);
a first dielectric layer (412) formed under the first electrode layer (411);
a second electrode layer (413) formed under the first dielectric layer (412); and
a second dielectric layer (414) formed under the second electrode layer (413).

5. The integrated digitizer display of claim 4, wherein the first electrode layer (411) comprises a coil electrode (711) running in a first direction, and the second electrode layer (413) comprises a coil electrode (721) running in a second direction, the second direction being perpendicular to the first direction.

6. The integrated digitizer display of claim 5, wherein the sensor electrode (410) further comprises a contact hole (810) formed in the first dielectric layer (412) for forming a loop coil by connecting the coil electrodes (711, 721) of the first electrode layer (411) and the second electrode layer (413).

## Patentansprüche

1. Integrierte Digitalisier-Anzeigevorrichtung, die umfasst:
ein TFT-Substrat (Thin Film Transistor substrate) (210), wobei an einer ersten Fläche desselben ein TFT und eine organische Lichtemissions-Schicht ausgebildet sind;
eine Sensor-Elektrode (14), die an einer zweiten Fläche des TFT-Substrats (210) ausgebildet ist, sowie
einen IC (Integrated Circuit) (24), der an die zweite Fläche des TFT-Substrats (210) gebondet ist, um die Integrierte Digitalisier-Anzeigevorrichtung anzusteuern,
wobei
die zweite Fläche der ersten Fläche gegenüberliegt,
die Sensor-Elektrode (410) so ausgeführt ist, dass sie ein externes Magnetfeld erfasst,
die Sensor-Elektrode (410) direkt mit dem TFT-Substrat (210) in Kontakt ist, und
eine Vielzahl von Kanälen für die Sensor-Elektrode (110) über den IC (410) an der zweiten Fläche des TFT-Substrats (210) verbunden sind.

2. Integrierte Digitalisier-Anzeigevorrichtung nach Anspruch 1, die des Weiteren eine flexible Leiterplatte (430) umfasst, die an der zweiten Fläche des TFT-Substrats (210) angeordnet ist und eine externe Schnittstelle der Digitalisierungsvorrichtung ist.

3. Integrierte Digitalisier-Anzeigevorrichtung nach Anspruch 1, die des Weiteren eine Magnetabschirmung (415) umfasst, die unter der Sensor-Elektrode (410) angeordnet ist.

4. Integrierte Digitalisier-Anzeigevorrichtung nach Anspruch 1, wobei die Sensor-Elektrode (410) umfasst:
eine erste Elektroden-Schicht (411), die unter dem TFT-Substrat (210) ausgebildet ist;
eine erste dielektrische Schicht (412), die unter der ersten Elektroden-Schicht (411) ausgebildet ist;
eine zweite Elektroden-Schicht (413), die unter der ersten dielektrischen Schicht (412) ausgebildet ist; sowie
eine zweite dielektrische Schicht (414), die unter der zweiten Elektroden-Schicht (413) ausgebildet ist.

5. Integrierte Digitalisier-Anzeigevorrichtung nach Anspruch 4, wobei die erste Elektroden-Schicht (411) eine Wendelelektrode (711) umfasst, die in einer ersten Richtung verläuft, und die zweite Elektroden-Schicht (413) eine Wendelelektrode (721) umfasst, die in einer zweiten Richtung verläuft, wobei die zweite Richtung senkrecht zu der ersten Richtung ist.

6. Integrierte Digitalisier-Anzeigevorrichtung nach Anspruch 5, wobei die Sensor-Elektrode (410) des Weiteren ein Kontakt-Loch (810) umfasst, das in der ersten dielektrischen Schicht (412) ausgebildet ist und durch Verbinden der Wendelelektroden (711, 721) der ersten Elektroden-Schicht (411) und der zweiten Elektroden-Schicht (413) eine geschlossene Wendel bildet.

## Revendications

1. Afficheur de numériseur intégré comprenant:
un substrat de transistor à couche mince, TFT (210), sur une première surface duquel sont formés un TFT et une couche électroluminescente organique;
une électrode de détection (410) formée sur une seconde surface du substrat TFT (210), et
un circuit intégré, IC (420), collé sur la seconde surface du substrat TFT (210) pour commander l'affichage de numériseur intégré, dans lequel la seconde surface est opposée à la première surface,
dans lequel l'électrode de détection (410) est configurée pour détecter un champ magnétique externe,
dans lequel l'électrode de détection (410) est en contact direct avec le substrat TFT (210), et
dans lequel une pluralité de canaux pour l'électrode de détection (410) sont connectés par le circuit intégré (410) sur la seconde surface du substrat TFT (210).

2. Affichage de numériseur intégré selon la revendication 1, comprenant en outre une carte à circuit imprimé flexible, FPCB (430), disposée sur la seconde surface du substrat TFT (210) pour constituer une interface externe du numériseur.

3. Affichage de numériseur intégré selon la revendication 1, comprenant en outre un écran magnétique (415) disposé sous l'électrode de détection (410).

4. Affichage de numériseur intégré selon la revendication 1, dans lequel l'électrode de détection (410) comprend:
une première couche d'électrode (411) formée sous le substrat TFT (210);
une première couche d'électrode (412) formée sous la première couche d'électrode (411);
une seconde couche d'électrode (413) formée sous la première couche diélectrique (412); et
une seconde couche diélectrique (414) formée sous la seconde couche d'électrode (413).

5. Affichage de numériseur intégré selon la revendication 4, dans lequel la première couche d'électrode (411) comprend une électrode de bobine (711) s'étendant dans une première direction et la seconde couche d'électrode (413) comprend une électrode de bobine (721) s'étendant dans une seconde direction, la seconde direction étant perpendiculaire à la première direction.

6. Afficheur de numériseur intégré selon la revendication 5, dans lequel l'électrode de détection (410) comprend en outre un trou de contact (810) formé dans la première couche diélectrique (412) pour former une bobine en boucle en connectant les électrodes de bobine (711, 721) de la première couche d'électrode (411) et de la seconde couche d'électrode (413).
